Europäisches Patentamt

European Patent Office

Office européen des brevets

(11) Veröffentlichungsnummer: **0 250 935**
**A2**

(12) **EUROPÄISCHE PATENTANMELDUNG**

(21) Anmeldenummer: **87108194.9**

(22) Anmeldetag: **05.06.87**

(51) Int. Cl.⁴: **H03M 1/74**

(30) Priorität: **30.06.86 DE 3621934**

(43) Veröffentlichungstag der Anmeldung:
**07.01.88 Patentblatt 88/01**

(84) Benannte Vertragsstaaten:
**AT BE CH DE ES FR GB GR IT LI NL SE**

(71) Anmelder: **Siemens Aktiengesellschaft Berlin und München**
**Wittelsbacherplatz 2**
**D-8000 München 2(DE)**

(72) Erfinder: **Rettenmaier, Helmut, Dipl.-Ing.**
**Feyerabendstrasse 13**
**D-8930 Schwabmünchen(DE)**

(54) **Digital-Analog-Wandler.**

(57) Jede abschaltbare Konstantstromquelle besteht aus der Kombination einer schaltenden und einer geschalteten Konstantstromquelle. Der Stromausgang der geschalteten Konstantstromquelle ist über das Widerstandsnetzwerk mit dem Summationspunkt (S) verbunden und die schaltende Konstantstromquelle ist ausgangsseitig an den Versorgungsstrompfad der geschalteten Konstantstromquelle angeschlossen.

EP 0 250 935 A2

## Digital-Analog-Wandler

Die Erfindung betrifft einen Digital-Analog-Wandler nach dem Oberbegriff des Patentanspruchs 1.

Obwohl zunehmend die analogen Schaltungskomplexe in elektronischen Geräten durch digitale Steuerungen verdrängt werden, bleiben manche Anwendungsfälle der analogen Technik vorbehalten. Somit findet man in elektronischen Geräten nicht selten eine Mischung aus analoger und digitaler Technik, wobei die analogen Schaltungskomponenten hauptsächlich als Ein-Ausgabeeinheiten für eine digitale Steuerung dienen. Die Ausgabedaten einer analogen Einheit müssen, um von der digitalen Steuerung interpretiert werden zu können, von dem analogen Format in das digitale Format übersetzt werden, ebenso wie die von der digitalen Steuerung an eine analoge Einheit weitergegebenen Daten einer Wandlung unterzogen werden müssen. Eine gebräuchliche Art Information auf analoge Weise zu übermitteln besteht darin, in einem gewissen Zeitraster den Spannungswert eines Signals zu verändern und den jeweiligen Spannungswerten eindeutig eine Information zuzuordnen. Die Genauigkeit jeder Information unterliegt dabei theoretisch keinen Grenzen.

Beim digitalen Datenformat ist die Genauigkeit einer Information durch die Anzahl der Signalleitungen beschränkt.

Eine Analog-Digital-Wandlung bewirkt eine Unterteilung des größten vorkommenden Spannungswertes eines analogen Signals in eine Anzahl, der Zweierpotenz der Menge der digitalen Signale entsprechender Spannungsbereiche und ordnet jedem Spannungsbereich eindeutig einen digitalen Wert zu.

Die Digital-Analog-Wandlung dagegen ordnet jedem digitalen Wert eindeutig einen Spannungswert zu, und zwar in der Regel so, daß die digitalen Informationen mit ihrer binären Wertigkeit proportional zur Höhe der Spannungswerte abgebildet werden und die höchste binäre Wertigkeit dem maximalen Spannungswert des analogen Signals entspricht.

Zur Realisierung eines Digital-Analog-Wandlers ist das Prinzip der Summation gewichteter Ströme bekannt. Jedes digitale Eingangssignal eines Digital-Analog-Wandlers vermag bei Aktivierung einen seiner binären Wertigkeit entsprechend starken Strom zu erzeugen. Die Ströme werden addiert und verursachen dann an einem Lastwiderstand einen Spannungsabfall, der zum Wert der binären Kombination der digitalen Eingangssignale proportional ist.

Bei der Entwicklung von nach diesem Prinzip arbeitenden Digital-Analog-Wandlern trat dann das Problem auf, daß die Genauigkeit der einzelnen Ströme stark von den die Ströme ein-und ausschaltenden Komponenten beeinflußt wurden. Um diesem Problem zu begegenen, ist es nach dem Buch von Tietze und Schenk gekannt, zur Erzeugung der einzelnen Ströme Konstantstromquellen zu benützen ("Halbleiterschaltungstechnik, 5. Auflage, Seite 640 und 641). Jedem digitalen Eingangssignal ist eine Konstantstromquelle zugeordnet, deren Konstantstrom proportional zur binären Wertigkeit des betreffenden digitalen Eingangssignals über ein Leiternetzwerk einge stellt ist. Jede Konstantstromquelle gibt dabei über zwei als Umschalter wirkende Dioden, abhängig vom zugehörigen digitalen Eingangssignal, entweder den erzeugten Konstantstrom an einen Summationspunkt, oder an das digitale Eingangssignal ab.

Durch die unterschiedlichen Ströme der Konstantstromquellen, die Umschaltzeiten der Dioden und die Instabilität bezüglich Versorgungsspannungsschwankungen genügt dieser Digital-Analog-Wandler nicht den erhöhten Anforderungen, wie sie z.B. bei der Ansteuerung hochauflösender Monitore nötig ist.

Die Aufgabe der Erfindung ist es demnach, den Aufbau des zuletzt genannten Digital-Analog-Wandlers so zu verbessern, daß er bei möglichst geringem schaltungstechnischem Aufwand den Anforderungen in hochauflösenden Monitoren genügt.

Gelöst wird die Aufgabe erfindungsgemäß durch die im kennzeichnenden Teil des Patentanspruchs 1 angegebenen Merkmale.

Bei einem derartigen Digital-Analog-Wandler sind, bedingt durch gleiche Konstantströme, die Schaltzeiten der einzelnen abschaltbaren Konstantstromquellen unabhängig von der jeweiligen zugeordneten binären Wertigkeit und untereinander gleich, womit unerwünschte kurzzeitige Zwischenwerte im zu erzeugenden Analogsignal vermieden werden.

Vorteilhafte Ausbildungen der Erfindung ergeben sich aus den Unteransprüchen.

Mit dem einstellbaren Spannungskonstanthalter, der bezüglich der Versorgungsspannung eine konstante Spannung liefert, ist nicht nur die Möglichkeit gegeben, den maximalen Spannungswert des zu erzeugenden Analogsignals präzise einzustellen, sondern es wird auch eine fast völlige Unabhängigkeit der Spannungswerte des zu erzeugenden Analogsignals von der Versorgungsspannung erzielt.

Die Erfindung wird im folgenden anhand eines Ausführungsbeispiels erläutert.

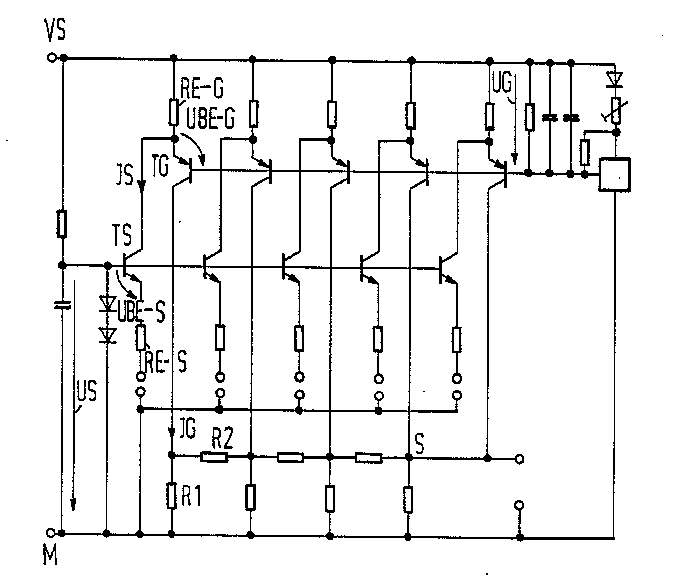

In der Figur ist eine Schaltungsanordnung eines erfindungsgemäßen Digital-Analog-Wandlers mit fünf, den digitalen Eingangssignalen zugeordneten abschaltbaren Konstantstromquellen, dargestellt, der z.B. als Video-Digital-Analog-Wandler zur Erzeugung eines sogenannten BAS-Signals verwendet werden kann.

Die Figur zeigt die untereinander identisch aufgebauten abschaltbaren Konstantstromquellen, die jeweils aus einer geschalteten Konstantstromquelle, deren Konstantstrom IG einem Widerstandsnetzwerk zugeführt wird und aus zugehörigen - schaltenden Konstantstromquellen bestehen, die von den digitalen Eingangssignalen angesteuert werden. Des weiteren zeigt die Figur die Schaltungskomponenten zur Erzeugung der von allen abschaltbaren Konstantstromquellen gemeinsam genützten Konstantspannungsquellen für die geschalteten und schaltenden Konstantstromquellen.

Im folgenden wird nur auf eine der abschaltbaren Konstantstromquellen Bezug genommen, da sie untereinander sowohl im Aufbau als auch in der Funktion übereinstimmen.

Eine abschaltbare Konstantstromquelle besteht aus der Kombination einer schaltenden und einer geschalteten Konstantstromquelle. Die geschaltete Konstantstromquelle wird von einem P-N-P-Transistor TG gebildet, dessen Emitteranschluß über einen Emitterwiderstand RE-G an eine Versorgungsspannung VS, z.B. in der Höhe von 5 Volt angeschlossen ist. Dem Basisanschluß dieses P-N-P-Tansistors TG wird von einem einstellbaren Spannungskonstanthalter eine bezüglich der Versorgungsspannung VS konstante Spannung UG, z.B. 2,5 Volt zugeführt. Der Kollektoranschluß des P-N-P-Transistors TG ist über einen Arbeitswiderstand R1 mit dem Massepotential M verbunden.

Die schaltende Konstantstromquelle wird mit einem N-P-N-Transistor TS realisiert, dessen Emitteranschluß über einen Emitterwiderstand RE-S mit einem digitalen Signal verbunden ist. Dem Basisanschluß des N-P-N-Tansitors TS wird eine bezüglich des Massepotentials M konstante Spannung US, z.B. 1,5 Volt zugeführt, die dem Abgriff eines an der Versorgungsspannung VS liegenden Spannungsteilers mit einem aus einer Serienschaltung von Dioden gebildeten massebezogenen Zweig entnommen wird. Der Kollektoranschluß des N-P-N-Transistors TS ist mit dem Emitteranschluß des P-N-P-Transistors TG verbunden.

Die schaltende Konstantstromquelle wird von dem zugehörigen digitalen Signal aktiviert. Weist das digitale Signal einen H-Pegel auf, sperrt der N-P-N-Transistor TS, denn das digitale Signal hebt mit dem H-Pegel das Emitterpotential sogar über das konstante Basispotential. Folglich vermag im Kollektorstrompfad des N-P-N-Transistors TS kein Konstantstrom IS zu fließen. Der P-N-P-Transistor TG der geschalteten Konstantstromquelle dagegen ist durchgeschaltet und in seinem Kollektorstrompfad fließt ein Konstantstrom IG, der sich bei Vernachlässi gung eines Basistroms aus der Formel

$$IG = \frac{UG - UBE\text{-}G}{RE\text{-}G}$$

ergibt, wobei UBE-G bei einem Siliziumtransistor in etwa mit 0,6 Volt anzunehmen ist. Dieser Konstantstrom IG erzeugt an dem Arbeitswiderstand R1 einen entsprechenden Spannungsabfall.

Ein L-Pegel des digitalen Signals aktiviert die - schaltende Konstantstromquelle. Der Transistor TS wird leitend und somit stellt sich ein Kontaktstrom IS ein, der sich unter Außerachtlassung eines Basisstroms mit der Formel

$$IS = \frac{US - UBE\text{-}S - U_{L\text{-}Pegel}}{RE\text{-}S}$$

berechnen läßt, wobei $U_{L\text{-}Pegel}$ den Spannungswert des digitalen Signals bei L-Pegel bezeichnet, und der Wert von UBE-S in etwa 0,6 Volt beträgt.

Der konstante Kollektorstrom IS des N-P-N-Transistors TS muß so groß sein, daß er am Emitterwiderstand RE-G einen so großen Spannungsabfall erzeugen kann, daß der P-N-P-Transistor TG sperrt und damit keinen Konstantstrom IG liefert. Um schnelle Schaltvorgänge in der abschaltbaren Konstantstromquelle zu erzielen, sollte der in der - schaltenden Konstantstromquelle erzeugte Konstantstrom IS z.B. eineinhalb mal so groß sein wie der Konstantstrom IG der geschalteten Konstantstromquelle. Allerdings ist ein Betrieb des N-P-N-Transistors TS und des P-N-P-Transistors TG im Sättigungsbereich grundsätzlich zu vermeiden.

Ein erfindungsgemäßer Digital-Analog-Wandler weist eine Anzahl von Eingängen für digitale Signale auf, denen je eine abschaltbare Konstantstromquelle zugeordnet ist. Die binäre Wertigkeit des jeweiligen digitalen Signals und damit der spannungsmäßige Beitrag am Spannungswert eines zu bildenden Analogsignals wird in einem Widerstandsnetzwerk festgelegt. Dieses Widerstandsnetzwerk setzt sich sowohl aus den Arbeitswiderständen R1 zusammen, über die die jeweiligen Kollektoranschlüsse, der die geschalteten Konstantstromquellen bildenden P-N-P-Transistoren TG mit dem Massepotential M verbunden sind, als auch aus Summierwiderständen R2, über die letztgenannte Kollektoranschlüsse derart verbunden sind, daß diejenige abschaltbare Konstantstromquelle mit der jeweils niedrigeren binären Wertigkeit mit derjenigen der nächsthöheren binären Wertigkeit gekoppelt ist. Der Kollektoranschluß des die geschaltete Konstantstromquelle mit der höchsten binären Wertigkeit bildenden P-N-P-Transistors TG ist Summationspunkt S der über die Summierwiderstände R2 fließenden Teilströme und stellt den Ausgang des Digital-Analog-Wandlers dar.

Das Widerstandsnetzwerk kann auch so dimensioniert werden, daß sich der am Summationspunkt S einstellende jeweilige Spannungswert nicht proportional zur binären Wertigkeit der digitalen Information erhöht.

In manchen Fällen kann man auf die Arbeitswiderstände R1 derjenigen abschaltbaren Konstantstromquellen verzichten, deren binäre Wertigkeit zwischen der niedrigsten und der höchsten im Digital-Analog-Wandler vorkommenden binären Wertigkeiten liegen.

Da der in der Figur dargestellte Digital-Analog-Wandler zur Erzeugung eines sogenannten BAS-Signals mit 16 Helligkeitswerten dient, ist zur eindeutigen Unterscheidung eines Synchronimpulses (z.B. 0 Volt) vom niedrigsten Helligkeitswert (z.B. 0,3 Volt) ein weiterer Eingang als Synchroneingang und damit eine weitere abschaltbare Konstantstromquelle vorgesehen. Diese weitere abschaltbare Konstantstromquelle ist an den Kollektoranschluß des die geschaltete Konstantstromquelle mit der höchsten binären Wertigkeit bildenden P-N-P-Transistors TG ohne Summierwiderstand R2 an den Summationspunkt S angeschlossen, und unterscheidet sich von den bestehenden abschaltbaren Konstantstromquellen lediglich durch andere Konstantströme.

## Ansprüche

1. Digital-Analog-Wandler mit einer Anzahl von Eingängen für digitale Signale, denen je eine abschaltbare Konstantstromquelle zugeordnet ist, deren Versorgungsstrom von einem Widerstandsnetzwerk entsprechend einer binären Wertigkeit des zugehörigen digitalen Signals gewichtet ist und deren Stromausgang an einen Summationspunkt (S) angeschlossen ist, **dadurch gekennzeichnet,** daß die abschaltbare Konstantstromquelle aus der Kombination einer - schaltenden und einer geschalteten Konstantstromquelle besteht, daß der Stromausgang der geschalteten Konstantstromquelle über das Widerstandsnetzwerk mit dem Summationspunkt (S) verbunden ist und daß die schaltende Konstantstromquelle ausgangsseitig an den Versorgungsstrompfad der geschalteten Konstantstromquelle angeschlossen ist.

2. Digital-Analog-Wandler nach Anspruch 1, **dadurch gekennzeichnet,** daß die schaltende und die geschaltete Konstantstromquelle aus je einem Transistor (TS,TG) gebildet sind und daß der jeweilige Emitteranschluß mit dem ersten Anschluß je eines Emitterwiderstandes (RE-S,RE-G) verbunden ist, deren jeweils zweiter Anschluß bezüglich des Basisanschlusses des zugehörigen Transistors (TS,TG) mit einer konstanten Spannung (US,UG) beaufschlagt ist.

3. Digital-Analog-Wandler nach Anspruch 2, **dadurch gekennzeichnet,** daß der zweite Anschluß des Emitterwiderstandes (RE-G) in der geschalteten Konstantstromquelle mit der Versorgungsspannung (VS) beaufschlagt ist, daß der zweite Anschluß des Emitterwiderstandes (RE-S) in der schaltenden Konstantstromquelle in aktiviertem Zustand der schaltenden Konstantstromquelle auf Massepotential (M) oder auf einem dem Massepotential (M) spannungsmäßig nächstgelegenen logischen Pegel liegt, daß der Kollektoranschluß des die schaltende Konstantstromquelle bildenden Transistors (TS) mit dem Emitteranschluß des die geschaltete Konstantstromquelle bildenden Transistors (TG) verbunden ist und daß dessen Kollektoranschluß an das Widerstandsnetzwerk angeschlossen ist.

4. Digital-Analog-Wandler nach Anspruch 2 oder Anspruch 3, **dadurch gekennzeichnet,** daß der zweite Anschluß des Emitterwiderstandes (RE-S) in der schaltenden Konstantstromquelle mit dem digitalen Signal beaufschlagt ist.

5. Digital-Analog-Wandler nach einem der vorhergehenden Ansprüche, **dadurch gekennzeichnet,** daß zur Erzeugung der konstanten Spannung (UG) für die geschalteten Konstantstromquellen ein einstellbarer Spannungskonstanthalter vorgesehen ist.

6. Digital-Analog-Wandler nach einem der vorhergehenden Ansprüche, **dadurch gekennzeichnet,** daß das Widerstandsnetzwerk in der Weise gebildet ist, daß die Kollektoranschlüsse der die geschalteten Konstantstromquellen bildenden Transistoren (TG) wenigstens in den mit der höchsten und mit der geringsten binären Wertigkeit behafteten abschaltbaren Konstantstromquellen über je einen Arbeitswiderstand (R1) mit dem Massepotential (M) verbunden sind, daß die Kollektoranschlüsse der die geschalteten Konstantstromquellen bildenden Transistoren (TG) über Summierwiderstände (R2) untereinander derart verbunden sind, daß abhängig von der binären Wertigkeit der abschaltbaren Konstantstromquellen diejenige mit der jeweils geringeren binären Wertigkeit mit der derjenigen der nächsthöheren binären Wertigkeit verbunden ist und daß der Kollektoranschluß des die geschaltete Konstantstromquelle mit der höchsten Wertigkeit bildenden Transistors (TG) als Summationspunkt (S) dient.

7. Digital-Analog-Wandler nach einem der vorhergehenden Ansprüche,

**dadurch gekennzeichnet,** daß an den aus einer Anzahl abschaltbarer Konstantstromquellen bestehenden Digital-Analog-Wandler eine weitere abschaltbare Konstantstromquelle derart angeschlossen ist, daß der Kollektoranschluß des die geschaltete Konstantstromquelle bildenden Transistors (TG) an den Summationspunkt (S) angeschlossen ist.